# EUROPEAN PATENT APPLICATION

(11) **EP 2 460 763 A2**
(43) Date of publication of application: **06.06.2012**
(21) Application number: 11191180.6
(22) Date of filing: 29.11.2011
(51) Int. Cl.: B81C 1/00

(54) **Wafer level packaging process for MEMS devices**

(30) Priority: 01.12.2010 US 957928
(71) Applicant: Honeywell International, Inc., Morristown, New Jersey 07962-2245 (US)
(72) Inventor: Horning, Robert D., Morristown, NJ New Jersey 07962-2245 (US); Ridley, Jeff A., Morristown, NJ New Jersey 07962-2245 (US)
(74) Representative: Buckley, Guy Julian

(57) **Abstract**

A process for packaging micro-electro-mechanical systems (MEMS) devices comprises providing a lower cover wafer and an upper cover wafer, providing a semiconductor wafer including a plurality of MEMS devices on a substrate layer, bonding the semiconductor wafer to a first surface of the lower cover wafer, and bonding a second surface of the upper cover wafer to the semiconductor wafer. The first surface of the lower cover wafer and the second surface of the upper cover wafer define a plurality of hermetically sealed cavity sections when bonded to the semiconductor wafer such that each of the MEMS devices is located inside one of the sealed cavity sections. A plurality of holes are formed that extend from the first surface of the upper cover wafer to the second surface of the upper cover wafer after the upper cover wafer is bonded to the semiconductor wafer. A metal lead layer is then deposited in each of the holes to provide an electrical connection with the MEMS devices.

## Description

### BACKGROUND

Micro-electro-mechanical systems (MEMS) devices are typically formed with semiconductor fabrication techniques to create small mechanical structures on a surface of a substrate such as a silicon wafer. In the production of MEMS devices such as gyroscopes or accelerometers, such semiconductor fabrication techniques are often used to create a number of moving structures that can be used to sense displacement in response to rotation or acceleration of the device about an input or rate axis.

High performance MEMS gyroscopes must be packaged in a vacuum, while MEMS accelerometers need to be packaged in gas. Both atmospheres of vacuum and gas must be stable over time, which means that all seals must be hermetic. A hermetic seal around the MEMS device also protects it from dust and damage during fabrication, post-fabrication handling, and operation. Since packaging of MEMS devices is often done one at a time, or in relatively small batches, the packaging process tends to be expensive.

Wafer level packaging (WLP) reduces costs by doing the packaging in batch fabrication as well as often allowing a simpler, cheaper final package to be used. For these reasons, a large number of approaches to WLP have been devised. Nevertheless, few approaches have been commercially successful because the requirements are stringent and difficult to achieve.

Most WLP designs provide a hermetically-sealed cover over the MEMS device. In high-performance devices that utilize MEMS gyroscopes and accelerometers, not only is a hermetically-sealed cover required, but also the cover needs to be a precisely-defined distance from the device for use as an "upper sense plate." This spacing requirement makes WLP even more difficult since it severely limits the choices available for bonding the cover to the device. The easiest bonding technologies (e.g., adhesives, solders, frits, etc.) introduce large, uncontrolled gaps between the cover and the device and are, therefore, not suitable.

### SUMMARY

A process for packaging micro-electro-mechanical systems (MEMS) devices comprises providing a lower cover wafer having a first surface and an opposing second surface, providing an upper cover wafer having a first surface and an opposing second surface, providing a semiconductor wafer including a plurality of MEMS devices on a substrate layer, bonding the semiconductor wafer to the first surface of the lower cover wafer, and bonding the second surface of the upper cover wafer to the semiconductor wafer. The first surface of the lower cover wafer and the second surface of the upper cover wafer define a plurality of hermetically sealed cavity sections when bonded to the semiconductor wafer such that each of the MEMS devices is located inside one of the sealed cavity sections. A plurality of holes are formed that extend from the first surface of the upper cover wafer to the second surface of the upper cover wafer after the upper cover wafer is bonded to the semiconductor wafer. A metal lead layer is then deposited in each of the holes to provide an electrical connection with the MEMS devices.

### BRIEF DESCRIPTION OF THE DRAWINGS

Features of the present invention will become apparent to those skilled in the art from the following description with reference to the drawings. Understanding that the drawings depict only typical embodiments and are not therefore to be considered limiting in scope, the invention will be described with additional specificity and detail through the use of the accompanying drawings, in which:

Figures 1A-1F illustrate a process for fabricating a MEMS device according to one approach;

Figure 2 is a cross-sectional side view of a hermetically sealed MEMS device according to one embodiment; and

Figure 3 is a plan view of a hermetically sealed MEMS device according to one embodiment.

### DETAILED DESCRIPTION

In the following detailed description, embodiments are described in sufficient detail to enable those skilled in the art to practice the invention. It is to be understood that other embodiments may be utilized without departing from the scope of the invention. The following detailed description is, therefore, not to be taken in a limiting sense.

A wafer level packaging process for micro-electro-mechanical systems (MEMS) devices is provided. The packaging process is compatible with MEMS inertial sensors such as accelerometers and gyroscopes. The packaging process allows for lower cost, higher reliability, and smaller sensors. The present approach to wafer level packaging of MEMS devices is an improvement over conventional methods.

For example, in one conventional approach, a silicon wafer containing MEMS structures is anodically bonded to a lower glass substrate. The MEMS structures are contained in an epitaxial layer of the silicon wafer, and the remainder of the wafer is removed by silicon etching. Prior to etching, holes are formed in the lower glass substrate. The holes open on to conductive silicon pads that maintain a hermetic seal around the hole and also provide a path for electrical connection from the back of the lower glass substrate to the MEMS device, which will eventually be inside a sealed cavity. Following the hole formation, the silicon substrate is removed as described above, and metal is deposited on the back of the lower glass substrate and in the holes. Finally, an upper glass wafer is anodically bonded to the silicon, sealing the device in a cavity containing gas (for an accelerometer) or vacuum (for a gyroscope).

In the conventional approach described above, the holes are made in the lower glass substrate prior to upper glass bonding because an electrical contact to all silicon features is required during anodic bonding of the upper glass substrate. This approach, however, makes the wafers fragile as the holes significantly weaken the lower glass substrate. Since the silicon MEMS device, after removal of its substrate, is quite thin, the device adds little or no structural support to make up for the holes in the lower glass substrate. Therefore, the glass is fragile and subject to breaking during subsequent fabrication steps, reducing wafer yield.

In the present approach to wafer level packaging of MEMS devices, the holes are not formed in the glass wafer when it is thin and fragile. In the present technique, the holes are only formed at the end of the process when the bonded wafers are double in thickness and, therefore, more rigid and robust. As the bonded wafers provide vastly improved rigidity, and there are so few handling steps left in the process, the bonded wafers can accommodate the larger number of holes needed for MEMS gyroscopes.

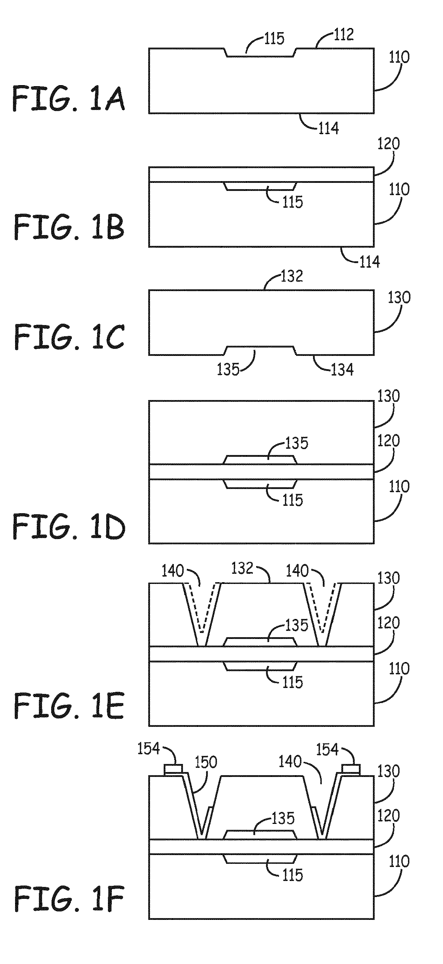

Figures 1A-1F illustrate a process for packaging one or more MEMS devices according to the present approach. As shown in Figure 1A, a lower cover wafer 110 such as a glass wafer is provided. The lower cover wafer 110 has a first surface 112 and an opposing second surface 114. The lower cover wafer 110 can be fabricated to include one or more recesses 115 such as etched wells, as well as metallization patterns and lines, electrodes, and the like. For example, the lower cover wafer 110 can include short metal runners, which are configured to provide electrical contact (via a "wraparound contact") to the MEMS devices during upper cover wafer bonding (discussed below).

A semiconductor wafer 120 such as a silicon wafer is provided that includes one or more MEMS devices on a substrate layer. The MEMS devices include various microstructures contained in an epitaxial layer on the substrate layer of semiconductor wafer 120. The MEMS devices can include one or more MEMS inertial sensors, such as one or more gyroscopes and/or one or more accelerometers, which have been prefabricated in semiconductor wafer 120 by standard techniques.

As depicted in Figure 1B, semiconductor wafer 120 is bonded to first surface 112 of lower cover wafer 110, using a standard bonding technique such as anodic bonding. The substrate layer can be removed by etching after semiconductor wafer 120 is bonded to lower cover wafer 110. Exemplary etchants for removing the substrate layer include Potassium Hydroxide (KOH), a mixture of Ethylene, Diamine, and Pyrocatechol (EDP), or a combination thereof.

As shown in Figure 1C, an upper cover wafer 130 is provided having a first surface 132 and an opposing second surface 134. The upper cover wafer 130 is substantially a mirror image of lower cover wafer 110 (minus a few features), and can also be fabricated to include one or more recesses 135 such as etched wells, as well as metallization patterns and lines, electrodes, and the like. If the final atmosphere is intended to be a vacuum, it is preferable to also deposit a gettering material such as Ti or Zr onto any areas of the surface that are not used for electrodes, leads, or the like. The upper cover wafer 130 is bonded to semiconductor wafer 120 on lower cover wafer 110, such as by anodic bonding second surface 134 to semiconductor wafer 120 as depicted in Figure 1D. The recesses 115 and 135 are aligned with each other after upper cover wafer 130 is bonded to semiconductor wafer 120 such that a MEMS device is located inside of a sealed cavity section formed by recesses 115 and 135.

When the metal runners are present on lower cover wafer 110, the metal runners electrically short all metal and silicon features together. If the metal runners are not present, any flexible structure on the silicon wafer 120 would be pulled up during bonding by the electrostatic force, and be bonded to the upper substrate 130. After bonding the metal runners can be cut using laser trimming through lower cover wafer 110. The bonding step in Figure 1D must be done in an atmosphere consistent with the final desired atmosphere. For example, if the final atmosphere is intended to be a vacuum, then bonding must be done in a vacuum.

As illustrated in Figure IE, a plurality of holes 140 are formed through first surface 132 of upper cover wafer 130. The holes 140 can be formed by sandblasting through a portion of upper cover wafer 130, and then etching through a remaining portion of upper cover wafer 130. The etching through upper cover wafer 130 can be carried out with a standard etchant such as hydrofluoric acid (HF).

As shown in Figure 1F, a metal lead layer 150 is deposited in each of holes 140 to provide electrical contact with the MEMS devices in semiconductor wafer 120. A bond pad 154 is formed adjacent to each of holes 140 on first surface 132 of upper cover wafer 130. The bond pads 154 are electrically coupled to metal lead layers 150.

In an alternative approach, the foregoing process steps are carried out as described above for Figures 1A-1F, except that the holes are formed through the second surface 114 of lower cover wafer 110 after upper cover wafer 130 is bonded to semiconductor wafer 120.

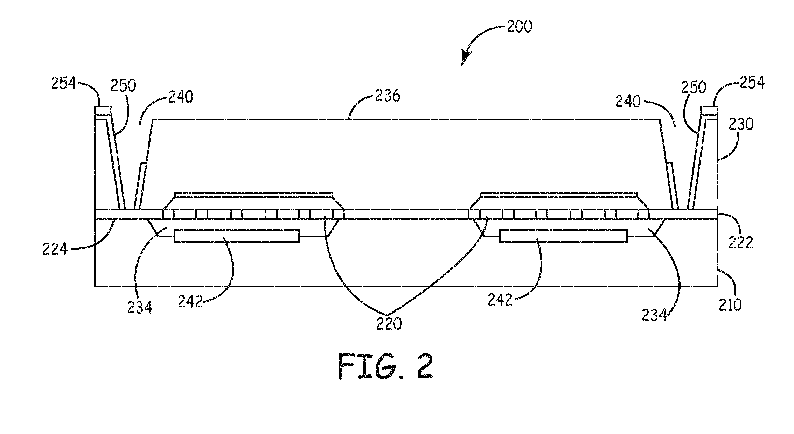

Figure 2 is a cross-sectional side view of a hermetically sealed MEMS device 200 according to one embodiment that can be fabricated according to the process steps described above for Figures 1A-1F. The sealed MEMS device 200 includes a lower cover plate 210 and an upper cover plate 230, both of which can be formed from glass wafers. A MEMS device mechanism 220, such as an inertial sensor, is sandwiched between upper cover plate 210 and lower cover plate 230. The MEMS device mechanism 220 is patterned in an interior portion of a mechanism substrate 222, which can be an epitaxial layer of silicon grown on a silicon wafer. The lower and upper cover plates 210, 230 are bonded to mechanism substrate 222 such as by anodic bonding.

The lower and upper cover plates 210, 230 are processed with appropriate mechanism support and trough structures prior to bonding with mechanism substrate 222 such that cover plates 210, 230 cooperate with MEMS device mechanism 220 when assembled together. The mechanism support and trough structures define a plurality of sealed cavity sections 234 when cover plates 210, 230 are bonded with mechanism substrate 222. The MEMS device mechanism 220 is located inside of sealed cavity sections 234. The cover plates 210, 230 can be formed in respective glass wafers of a type having a thermal expansion coefficient substantially matched to that of silicon. Examples such glass wafers include Coming Pyrex, Schott Borofloat 33, or Hoya SD2.

A plurality of holes 240 extend through upper cover plate 230 to a plurality of respective connecting portions 224 of mechanism substrate 222. The holes 240 are tapered inwardly from an external surface 236 of cover plate 230 to connecting portions 224. The connecting portions 224 are sized to completely seal off holes 240 from cavity sections 234. A plurality of metal runners 242, such as gold traces, are located in lower cover plate 210. The metal runners 242 may be partially submerged within shallow troughs formed on an inner surface of lower cover plate 210 prior to bonding with mechanism substrate 222.

A plurality of metal lead layers 250, such as gold traces, extend into each of holes 240 and provide electrical connection to MEMS device mechanism 220 through connecting portions 224. A plurality of bond pads 254 are located adjacent to each of holes 240 on an external surface 236 of upper cover plate 230. The bond pads 254 are electrically coupled to metal lead layers 250 and provide for routing signals into and out of sealed MEMS device 200.

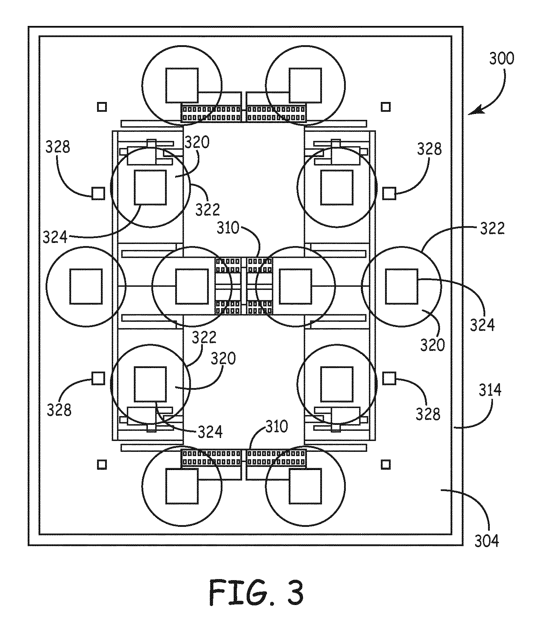

Figure 3 is a plan view of a hermetically sealed MEMS device 300 according to one embodiment that can be fabricated according to the process steps described above for Figures 1A-1F. The MEMS device 300 includes a device mechanism 310 such as a gyroscope mechanism formed from a silicon wafer, which is sandwiched between an upper glass plate 304 and a lower glass plate (not shown), such as depicted for the MEMS device of Figure 2. The MEMS device 300 also includes a support frame 314 such as a silicon frame that surrounds an outer periphery of MEMS device 300. The glass plates are each bonded to opposing sides of frame 314 and device mechanism 310, such as by anodic bonding, to provide a hermetic seal for MEMS device 300.

A plurality of holes 320 each extend through upper glass plate 304 to a plurality of connecting portions 324. The holes 320 taper inwardly such that their diameters are larger at the top of glass plate 304 and smaller where holes 320 meet connecting portions 324. A plurality of metal lead layers 322 extend into each of holes 320 and provide electrical connections to device mechanism 310 through connecting portions 324. A plurality of bond pads 328 are located adjacent to holes 320 on an external surface of glass plate 304 and are within support frame 314. This allows all electrical connections to device mechanism 310 to be made from inside of support frame 314.

The present invention may be embodied in other specific forms without departing from its essential characteristics. The described embodiments are to be considered in all respects only as illustrative and not restrictive. The scope of the invention is therefore indicated by the appended claims rather than by the foregoing description. All changes that come within the meaning and range of equivalency of the claims are to be embraced within their scope.

## Claims

1. A process for packaging micro-electro-mechanical systems (MEMS) devices, the process comprising:
providing a lower cover wafer having a first surface and an opposing second surface;
providing an upper cover wafer having a first surface and an opposing second surface;
providing a semiconductor wafer including a plurality of MEMS devices on a substrate layer;
bonding the semiconductor wafer to the first surface of the lower cover wafer;
bonding the second surface of the upper cover wafer to the semiconductor wafer, wherein the first surface of the lower cover wafer and the second surface of the upper cover wafer define a plurality of hermetically sealed cavity sections when bonded to the semiconductor wafer such that each of the MEMS devices is located inside one of the sealed cavity sections;
forming a plurality of holes extending from the first surface of the upper cover wafer to the second surface of the upper cover wafer after the upper cover wafer is bonded to the semiconductor wafer; and
depositing a metal lead layer in each of the holes to provide an electrical connection with the MEMS devices.

2. The process of claim 1, further comprising forming mechanism support and trough structures in the lower and upper cover plates prior to bonding with the semiconductor wafer such that the mechanism support and trough structures cooperate with the MEMS devices inside the sealed cavity sections during operation of the MEMS devices.

3. The process of claim 1, further comprising forming one or more bond pads adjacent to each of the holes on the first surface of the upper cover wafer, the bond pads electrically coupled to the metal lead layers.

4. The process of claim 1, wherein each of the hermetically sealed cavity sections contains a vacuum.

5. The process of claim 1, wherein each of the hermetically sealed cavity sections contains a damping gas at a predetermined pressure.

6. The process of claim 4, wherein the MEMS devices comprise MEMS gyroscopes.

7. The process of claim 5, wherein the MEMS devices comprise MEMS accelerometers.

8. The process of claim 1, further comprising removing the substrate layer from the semiconductor wafer prior to bonding the second surface of the upper cover wafer to the semiconductor wafer.

9. The process of claim 1, wherein the lower cover wafer includes one or more metal runners in the hermetically sealed cavity sections.

10. The process of claim 9, further comprising laser trimming the metal runners through the second surface of the lower cover wafer prior to forming the plurality of holes.
